# EUROPEAN PATENT SPECIFICATION

(11) **EP 1 264 395 B1**
(45) Date of publication and mention of the grant of the patent: **10.09.2003**
(21) Application number: 01912090.6
(22) Date of filing: 08.03.2001
(51) Int. Cl.: H03F 1/00

(54) **IMPROVED METHOD AND APPARATUS FOR IMPROVING THE EFFICIENCY OF POWER AMPLIFIERS, OPERATING UNDER A LARGE PEAK-TO-AVERAGE RATIO**
VERFAHREN UND VORRICHTUNG ZUR ERHÖHUNG DES WIRKUNGSGRADES VON LEISTUNGSVERSTÄRKERN BEI SIGNALEN MIT HOHEM SPITZENWERT- ZU MITTELWERTVERHÄLTNIS
PROCEDE ET APPAREIL PERFECTIONNES PERMETTANT D'AMELIORER L'EFFICACITE DES AMPLIFICATEURS DE PUISSANCE FONCTIONNANT AVEC UN RAPPORT DE VALEUR DE CRETE SUR VALEUR MOYENNE ELEVE

(30) Priority: 10.03.2000 US 188194 P; 26.09.2000 WO PCT/IL00/00599
(43) Date of publication of application: 11.12.2002
(73) Proprietor: Paragon Communications Ltd., 33095 Haifa (IL)
(72) Inventor: BAR-DAVID, Israel, 34982 Haifa (IL)
(74) Representative: Modiano, Guido, Dr.-Ing.
(86) International application number: IL0100221
(87) International publication number: WO01067593

(56) References cited:
- EP-A- 1 041 712
- US-A- 5 420 536
- US-A- 5 886 575
- US-A- 5 898 342
- US-A- 6 028 486
- NOJIMA T ET AL: "CIRCUIT TECHNOLOGY FOR MOBILE/PERSONAL COMMUNICATIONS" EUROPEAN MICROWAVE CONFERENCE PROCEEDINGS,GB,NEXUS BUSINESS COMMUNICATIONS, vol. CONF. 24, 5 September 1994 (1994-09-05), pages 220-229, XP000643169 ISBN: 0-9518-0325-5

## Description

The present invention relates to the field of power amplifiers. More particularly, the invention relates to a method and apparatus for improving the efficiency of power amplifiers operating under large peak-to-average ratios, while eliminating the need for clipping signals having large peak amplitudes.

### Background of the Invention

Modern communication systems, such as cellular systems employ power amplifiers in their basestations, in order to communicate with subscribers that are distributed in cells. These power amplifiers that are required to amplify Radio Frequency (RF) signals, such as signals used in communication systems that are required to transmit multiple signals, simultaneously. Multiple signals should be transmitted, for example, due to multiple users sharing the same frequency band, such as cellular systems that are operated in Code Division Multiple Access (CDMA) regimes. Another communication method that requires simultaneous transmissions employ, for example, a modulation format known as "multi-tone", or Orthogonal Frequency Division Multiplexing (OFDM), in which the signal from a single user is first subdivided. Each subdivision is then modulated by a multiplicity of staggered subcarriers. The modulated subcarriers are then added up, thus causing large peak excursions.

Conventional RF amplifiers required to simultaneously amplify RF signals that have large peak-to-average ratios, are costly and relatively inefficient (consuming much DC power). The reason for such inefficiency is that a power amplifier becomes efficient only during the occurrence of the peaks, i.e., when the instantaneous power output is large. However, during most of the time, the power output is only a small fraction of the power drain from the Direct Current (DC) power supply, resulting in low efficiency.

In order to reduce the average power loss, communication system designers use conventional techniques for reducing the peak to average ratio, based on clipping of the signal peaks. "Keeping noise mitigation for ODFM by decision-aided reconstruction" to Kim et al, IEEE Communications Letters, Vol. 3, No. 1, Jan 1999 and "Design considerations for multicarrier CDMA base station power amplifiers", to J.S. Kenney et al, Microwave Journal, Feb 1999, describe such techniques, which treat OFDM and multicarrier communications. It is also explained there that clipping considerably increases the undesired error rate of the system, and in some cases causes a partial spectral re-growth. Considerable effort is directed to mitigate the increase in the error rate while increasing the amount of clipping.

"Considerations on applying OFDM in a highly efficient power amplifier" to W. Liu et al, IEEE transactions on circuits and systems, Vol. 46, No. 11, Nov. 1999, relates to the classical Envelope Elimination and Reconstruction (EER) for OFDM. "Device and circuit approaches for next-generation wireless communications" to P. Asbeck et al, Microwave Journal, Feb. 1999, discloses similar features EER for OFDM, with sundry modifications for multicarrier transmission. However, all the above references depend on continuously varying power supplies for the envelope reconstruction or emphasis, which is difficult to achieve at large bandwidths and large peak to average ratios. Furthermore, EER techniques are mostly used for low-frequency modulation.

Andre (US 6,028,486) discloses a method and apparatus for reducing power dissipated by an amplifier circuit based on using two separate power supplies, each being capable of supplying power at different discrete levels of power. A first power supply generates power at a first power level when a magnitude of an input signal is less than or equal to a threshold and a second power supply generates power at a second power level, greater than the first power level, when a magnitude of an input signal is greater than the threshold. A controller switches the power level in response to the magnitude of the input signal. Although the power dissipation is reduced, the supply voltage does not follow the undulations of an input signal. Since the supply voltage is fed at two separate discrete levels and does not follow the undulations of an input signal, the reduction in power dissipation is therefore limited.

All the methods described above have not yet provided satisfactory solutions to the problem of improving the efficiency of power amplifiers operated under large peak-to-average ratios, while eliminating the need for clipping signals having large peak amplitudes.

It is an object of the present invention to provide a method and apparatus for improving the efficiency of power amplifiers operated under large peak-to-average ratios, while eliminating the need for clipping signals.

It is another object of the present invention to provide a method and apparatus for improving the efficiency of power amplifiers operated under large peak-to-average ratios, while eliminating spectral re-growth of unwanted sidebands.

It is still another object of the present invention to provide a method and apparatus for expanding the dynamic range of power amplifiers operated under large peak-to-average ratios.

Other objects and advantages of the invention will become apparent as the description proceeds.

### Summary of the Invention

The invention is defined as set out in the independent claims.

The present invention is directed to a method for improving the efficiency and the dynamic range of a power amplifier operated with signals having a large peak-to-average ratio. A reference level is determined, above which at least a portion of the magnitude of an input signal being a modulated signal that is input to the power amplifier, or a baseband waveform that is used to generate the modulated signal, is defined as an excess input signal. The magnitude of the input signal is continuously sampled, for detecting an excess input signal. A lower level of operating voltage is supplied to the power amplifier, if no excess input signal is detected. The lower level of operating voltage is sufficient to effectively amplify input signals having a magnitude below the reference level. A higher level of operating voltage is supplied to the power amplifier, whenever an excess input signal is detected. The higher level of operating voltage is sufficient to effectively amplify input signals having a magnitude above the reference level.

Preferably, an automatic gain control circuit is coupled to the input of the power amplifier, in order to control the magnitude of the input signal(s) prior to amplification. Whenever an excess input signal is detected, the excess input signal is sampled. Changes in the gain of the power amplifier during the presence of the excess input signal are compensated by controlling the gain of the automatic gain control circuit, according to the samples of the excess input signal.

The level of operating voltage is supplied to the power amplifier by a lower voltage source for feeding the power amplifier whenever no excess input signal is detected and a higher voltage source for feeding the power amplifier whenever an excess input signal is detected. The voltage supply contact of the power amplifier is connected to the lower voltage source through a first variable impedance, and may be connected to the higher voltage source through a second variable impedance. Whenever no excess input signal is detected, the first and the second variable impedances may be simultaneously controlled to be in an appropriate low, and highest impedance states, respectively. Whenever an excess input signal is detected, the first and the second variable impedances may be simultaneously controlled to be in their highest and an appropriate low impedance states, respectively.

Preferably, the level of operating voltage is supplied to the power amplifier by using another voltage source for feeding the power amplifier whenever an excess input signal is detected. The voltage supply contact of the power amplifier is connected to the first voltage source through a variable impedance, and to the another voltage source through a voltage amplifier. The variable impedance can present a low resistance to DC and high impedance for rapidly varying pulses. The variable impedance is allowed to reach an appropriate low resistance whenever no excess input signal is detected, and its high impedance whenever an excess input signal is detected. The voltage amplifier is allowed to supply a voltage level that is higher than the voltage of the first voltage source, to the voltage supply contact of the power amplifier, whenever an excess input signal is detected. At least one of the variable impedances may be an inductor or a diode, or a controllable impedance, such as a bipolar transistor or a FET.

Preferably, levels of operating voltage, supplied to the power amplifier, are normalized to corresponding predetermined levels of the excess input signal. The level of operating voltage supplied to the power amplifier sampled and an error signal is generated by comparing between the sampled level with the excess input signal. The error signal is used to operate a negative feedback loop for accurately controlling the operating voltage supplied to the power amplifier.

Alternatively, levels of operating voltage, supplied to the power amplifier, are normalized to corresponding predetermined levels of RF output signals, amplified by the power amplifier. The level of RF output signals, amplified by the power amplifier is sampled and an error signal is generated by comparing between the sampled level with the excess input signal. The error signal is used for operating a negative feedback loop for accurately controlling the operating voltage supplied to the power amplifier.

According to another aspect of the invention, the level of DC voltage, supplied to the power amplifier, is controlled, using the baseband waveform. A baseband signal source outputs the baseband waveform into a modulator, that generates a modulated input signal, which is fed into the power amplifier. A reference level, above which at least a portion of the baseband waveform, is defined as an excess baseband signal is determined. The magnitude of the baseband waveform is continuously sampled, for detecting an excess baseband signal. A lower level of operating voltage is supplied to the power amplifier, if no excess baseband signal is detected. The lower level of, operating voltage is sufficient to effectively amplify input signals, modulated with a baseband waveform of a magnitude below the reference level. A higher level of operating voltage is supplied to the power amplifier, whenever an excess baseband signal is detected. The higher level of operating voltage is sufficient to effectively amplify input signals that are modulated with a baseband waveform of a magnitude above the reference level.

According to a further aspect of the invention, the power amplifier may be the auxiliary amplifying circuitry of a Doherty configuration that consists of an auxiliary amplifier directly connected to the load, and a main amplifier coupled to said load through a Doherty coupler. A reference level is determined, above which at least a portion of the magnitude of an input signal being a modulated signal that is input to said power amplifier, or a baseband waveform that is used to generate the modulated signal, is defined as an excess input signal such that the reference level is essentially equal to the level of the input signal that causes the main and the auxiliary amplifier circuitries to output essentially the same power into the load, thereby reaching the maximal output power level under said DC operating voltage. The magnitude of the input signal is continuously sampled, for detecting an excess input signal. The input signal is continuously amplified with the main amplifier circuitry by supplying a constant operating voltage to said main amplifier circuitry. As long as no excess voltage is detected, the input signal is amplified by the auxiliary amplifier circuitry by supplying, to the auxiliary amplifier, the same DC operating voltage that is supplied to the main amplifier. Whenever an excess voltage is detected, an enhanced and higher level of DC operating voltage is supplied to the auxiliary amplifying circuitry. The enhanced level of operating voltage is sufficient to effectively amplify input signals having a magnitude above the reference level.

The present invention is also directed to an apparatus for improving the efficiency and the dynamic range of a power amplifier operated with signals having a large peak-to-average ratio. The apparatus comprises a sampling circuit for continuously sampling the magnitude of an input signal, which may be a modulated signal that is input to the power amplifier, or of a baseband waveform that is used to generate the modulated signal. The sampling circuit detects an excess input signal according to a predetermined reference level, above which at least a portion of the input signal is defined as an excess input signal; a power supply for indirectly supplying an operating voltage to the power amplifier; and a control circuit that operates in combination with the power supply, for causing the power supply to supply a lower level of operating voltage that is sufficient to effectively amplify input signals of a magnitude below the reference level, to the power amplifier, if no excess input signal is detected, and to supply a higher level of operating voltage that is sufficient to effectively amplify input signals of a magnitude above the reference level, to the power amplifier, whenever an excess input signal is detected.

The apparatus may further comprise:
a) an automatic gain control circuit, coupled to the input of the power amplifier, for controlling the magnitude of the input signal(s) prior to amplification;
b) circuitry for sampling the excess input signal; and
c) a control circuitry, for compensating changes in the gain of the power amplifier during the presence of the excess input signal by controlling the gain of the automatic gain control circuit, according to the samples of the excess input signal.

The apparatus may comprise:
a) a lower voltage source for feeding the power amplifier whenever no excess input signal is detected;
b) a higher voltage source for feeding the power amplifier whenever an excess input signal is detected;
c) a first variable impedance connected between the voltage supply input of the power amplifier and the lower voltage source;
d) a second variable impedance connected between the voltage supply input of the power amplifier and the higher voltage source; and
e) a control circuit for simultaneously controlling the first and the second variable impedances to be in an appropriate low, and highest impedance states, respectively, whenever no excess input signal is detected, and to be in their highest, and an appropriate low impedance states, respectively, whenever an excess input signal is detected.

Preferably, the apparatus comprises:
a) a first voltage source for feeding the power amplifier whenever no excess input signal is detected;
b) another voltage source for feeding the power amplifier whenever an excess input signal is detected;
c) a variable impedance connected between the voltage supply contact of the power amplifier and the first voltage source, the variable impedance being capable of presenting a low resistance to DC and high impedance for rapidly varying pulses;
d) a voltage amplifier connected between the voltage supply contact of the power amplifier and the another voltage source, for supplying a voltage level, being higher than the voltage of the first voltage source, to the voltage supply contact of the power amplifier;
e) a control circuit, for controlling the voltage amplifier to supply a voltage level, being higher than the voltage of the first voltage source, to the voltage supply contact of the power amplifier, whenever no excess input signal is detected, and if the variable impedance is a controllable impedance:
   for controlling the variable impedance to reach its high impedance value whenever an excess input signal is detected, and to reach, an appropriate low resistance whenever no excess input signal is detected.

At least one of the variable impedances of the apparatus may be an inductor or a diode, or a controllable impedance, such as a bipolar transistor or a FET. The apparatus may further comprise:
a) a sampling circuit for sampling the level of operating voltage supplied to the power amplifier;
b) a comparator for generating an error signal by comparing between the sampled level of operating voltage' supplied to the power amplifier, with the level of the excess input signal; and
c) a negative feedback loop for accurately controlling the operating voltage supplied to the power amplifier, by using the error signal.

The apparatus may further comprise:
a) a sampling circuit for sampling the level of RF output signals, amplified by the power amplifier;
b) a comparator for generating an error signal by comparing between the sampled level of RF output signals, amplified by the power amplifier, with the level of the excess input signal; and
c) a negative feedback loop for accurately controlling the operating voltage supplied to the power amplifier, by using the error signal.

Alternatively, the apparatus may further comprise:
a) a modulator for generating a modulated signal that is input to the power amplifier;
b) a baseband signal source for generating a baseband waveform that is input to the modulator;
c) a sampling circuit for continuously sampling the magnitude of the baseband waveform, for detecting an excess input signal according to a predetermined reference level, above which at least a portion of the baseband waveform is defined as an excess baseband signal;
d) a power supply for indirectly supplying an operating voltage to the power amplifier; and
e) a control circuit, operating in combination with the power supply, for causing the power supply to supply a lower level of operating voltage being sufficient to effectively amplify input signals having a magnitude below the reference level, to the power amplifier, if no excess input signal is detected, and to supply a higher level of operating voltage being sufficient to effectively amplify input signals having a magnitude above the reference level, to the power amplifier, whenever an excess input signal is detected.

The apparatus may be connected to a power amplifier being the auxiliary amplifying circuitry that is used in the *Doherty configuration*, such that the output of said auxiliary amplifying circuitry is directly connected to a load and is operated in combination with a main amplifie*r* that is coupled to said load through a *Doherty coupler*. The input of said auxiliary amplifying circuitry is coupled to the input of said main amplifier through a phase shifting circuitry that has essentially similar phase shift to the phase shift that is introduced by said *Doherty coupler.*

### Brief Description of the Drawings

The above and other characteristics and advantages of the invention will be better understood through the following illustrative and non-limitative detailed description of preferred embodiments thereof, with reference to the appended drawings, wherein:
- Figs. 1A and 1B schematically illustrate the waveform of the input signal to the power amplifier and the desired vaveform of the supply voltage to the power amplifier, respectively, according to a preferred embodiment of the invention;
- Fig. 2A is a block diagram of the basic circuit for controlling the supply voltage to the power amplifier, according to a preferred embodiment of the invention;
- Fig. 2B is a block diagram of a circuit for controlling the enhanced supply voltage to the power amplifier by feeding back part of the enhanced voltage, according to a preferred embodiment of the invention;
- Figs. 2C to 2E schematically illustrate computed simulated results of the supplied voltage with and without Excess Signal (ES) feedback, according to a preferred embodiment of the invention;
- Fig. 3 is a block diagram of a circuit for controlling the supply voltage to the power amplifier when there is access to baseband signals, according to a preferred embodiment of the invention;
- Fig. 4 is a block diagram of a circuit for controlling the supply voltage to the power amplifier with an output control, according to a preferred embodiment of the invention;
- Fig. 5 graphically illustrates analysis results of the expected improvement in efficiency, by utilizing the VEC in combination with the *Doherty configuration*; and
- Fig. 6 schematically illustrates a *Doherty configuration* that comprises a VEC for enhancing the DC supply voltage of its auxiliary amplifying circuitry, according to a preferred embodiment of the invention.

### Detailed Description of Preferred Embodiments

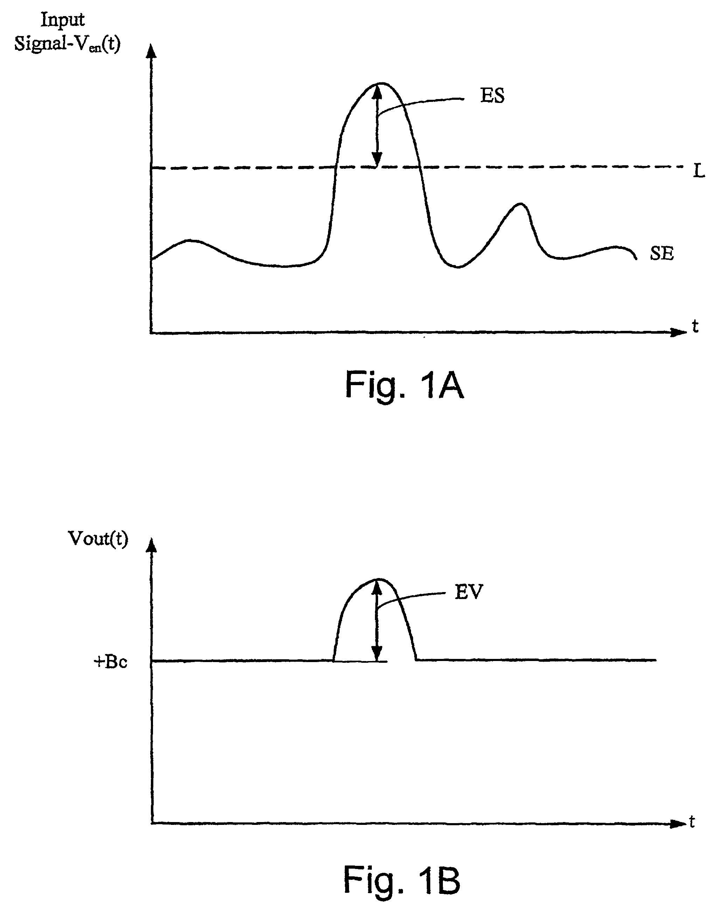

Figs. 1A and 1B schematically illustrate the waveform of the input signal to the power amplifier and the desired waveform of the supply voltage to the power amplifier, respectively, according to a preferred embodiment of the invention. The waveform *v*_{*en*}(*t*) in Fig. 1A illustrates the positive envelope of an input RF signal, input to the power amplifier. An Excess Signal (ES) occurs when the level of the Signal Envelope (SE) exceeds a predetermined Reference Level (*L*) defined by the system designer. The present invention provides a circuitry called Voltage Enhancement (VE) Circuitry (VEC), described further below, that causes the supply voltage to the RF amplifier to have the desired waveform, as shown in Fig. 1B: The supply voltage normally remains in a constant value, +B_{C}, (the subscript C for "conventional") and is varied (enhanced) only during the anomalous periods when the level of the input signal is higher than the predetermined Reference Level (*L*) (i.e., there is an ES). The resulting enhanced voltage (EV) waveform is a close replica of the ES waveform, as indicated by comparing between Figs. 1A and 1B.

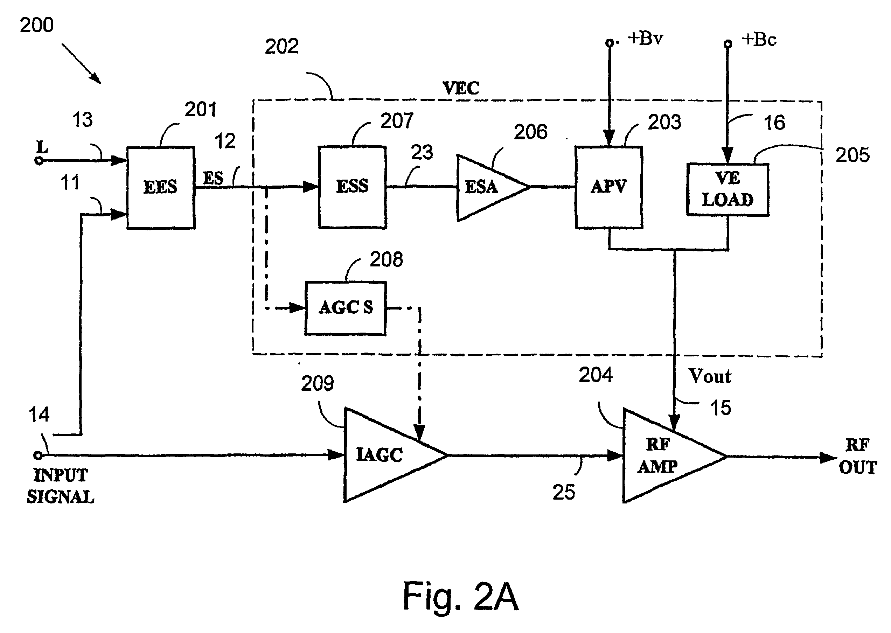

Fig. 2A is a block diagram of the basic circuit for controlling the supply voltage to the power amplifier, according to a preferred embodiment of the invention. The circuit 200 comprises an Excess Envelope Sensor (EES) 201, a VEC 202, RF stages 209, 204 and an input coupler at point 14. The RF power amplifier 204 is designed such that when there is no excess signal ES at point 12, the DC supply +B_{C} is sufficient to amplify the modulated RF signal at point 25 with the required fidelity. However, when signal 25 reaches peak values, the RF power amplifier 204 would be saturated if the voltage +B_{C} is supplied. Such peaks are sensed by the EES 201 that outputs the excess signal ES at point 12 resulting from these peaks, to the VEC block 202 which, in turn, appropriately enhances the voltage *v*ₒᵤₜ (*t*) (that appears at point 15), fed to the RF power amplifier 204. This is indeed, the enhanced voltage EV, introduced in Fig. 1B. Therefore, the RF power amplifier 204 with the enhanced supply voltage remains unsaturated when the input RF signal peaks occur, and the amplification remains adequate.

The EES 201 detects an ES by sampling the RF signal at the input 14, and comparing the sample that appears at input 11 of EES 201 to the reference level *L* that appears at input 13 of EES 201. EES 201 outputs the excess signal (ES) at point 12. The ES is then input to the VEC block 202, which is configured such that it outputs the desired supply voltage *v*ₒᵤₜ (*t*) (shown in Fig. 1B) at point 15, to the RF amplifier 204. During normal periods when there is no ES at point 12, the Analog Power Valve (APV) 203 is essentially in cut-off and the VE LOAD block 205 introduces a low DC resistance. Thus, the DC voltage +B_{C} at point 16 is fully applied to the RF amplifier 204. In this state, *v*ₒᵤₜ = +B_{C}, as indicated also in Fig. 1B above. On the other hand, the VE LOAD block 205 provides a high impedance to a positive pulse, such as a voltage enhancement pulse that is supplied by the Analog Power Valve (APV) 203 when the latter is excited by an ES. According to a preferred embodiment of the invention, the VE LOAD block 205 can be implemented using either an RF choke, or a diode with its anode connected to a voltage +B_{C}, or a voltage controlled transistor (such as a Field-Effect-Transistor (FET), or a bipolar transistor).

The APV block 203 can be implemented as a transistor, for example a Field-Effect Transistor (FET) or a bipolar transistor, and be conveniently biased to be normally in the cut-off state, except when excited by the output of the Excess Signal Amplifier (ESA) 206. The APV block 203 may be powered from a separate DC voltage source, Bᵥ. The optional Excess Signal Shaper (ESS) 207 that translates the ES to the input of ESA 206, is a memory-less, monotonic non-linearity. The purpose of ESA 206 is to output, at point 23, an altered shape of the Excess Signal that appears at point 12, in order to counteract possible non-linearities incurred in the APV block 203 and in the characteristics of the RF amplifier 204.

According to a preferred embodiment of the invention, the excess signal (ES) output at point 12 may also be used to adjust the overall gain of the RF chain during effectuation of the voltage enhancement (VE), for improved fidelity. Such option is shown by the dotted lines in Fig. 2A. The ES is appropriately conditioned by the AGC Shaper (AGCS) block 208, and then applied to control the gain of the instantaneous automatic gain control (IAGC) stage 209. The AGCS block 208, very much like the ESS 207, is also a memory-less monotonic nonlinearity. The concept behind the two shapers ESS 207, and AGCS 208 is the following: Basically, the voltage enhancement of the RF amplifier 204 is intended to increase its dynamic range. However, such VE will, to a certain extent, also increase the gain of the RF amplifier 204. The IAGC stage 209 is used to compensate the gain changes by decreasing its own gain accordingly. The transfer functions of the ESS 207 and the AGCS block 208 can be adjusted for linearity of gain, while the dynamic range is extended during the voltage enhancement period.

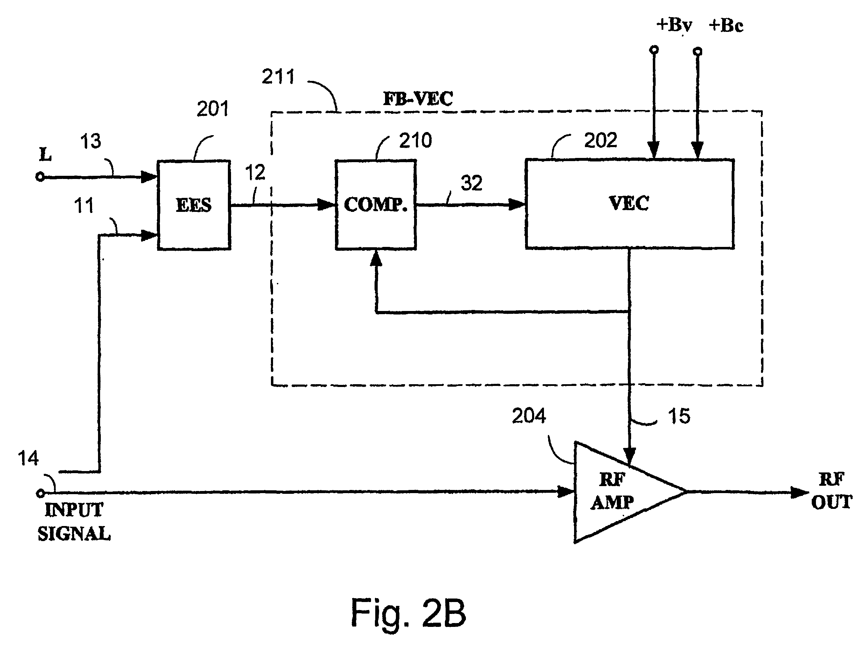

Fig. 2B is a block diagram of a circuit for controlling the enhanced supply voltage to the power amplifier by feeding back part of the enhanced voltage, according to a preferred embodiment of the invention. By using this option, it is possible to obtain better fidelity than by using the Excess Signal Shaper (ESS) block 207 alone, as shown in Fig. 2A hereinabove. A comparator 210 compares the output voltage *v*ₒᵤₜ (*t*) that appears at point 15, with the ES that appears at point 12. The difference voltage that appears at point 32 is fed into the VEC 202. This constitutes a modified Feed Back VEC (FB-VEC) indicated by the reference numeral 211 in Fig. 2B. Depending on the plurality of said difference voltage, the voltage amplification of the VEC 202 will either be increased or decreased, until the EV will track the ES.

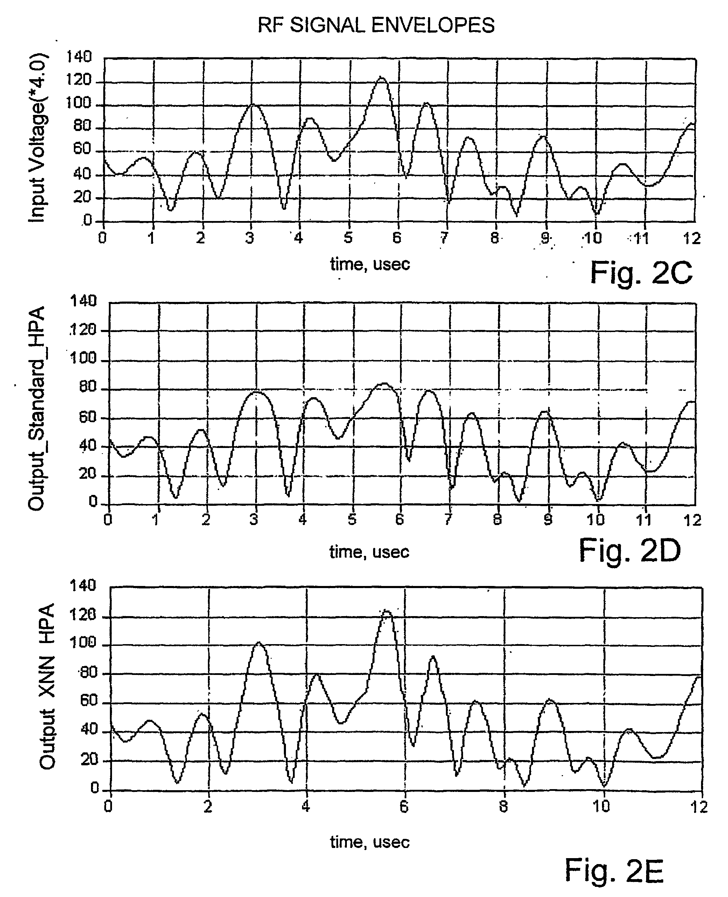

Figs. 2C to 2E schematically illustrate computer-simulated results of a conventional amplifier and of the FB-VEC of Fig. 2B, according to a preferred embodiment of the invention. The upper graph (Fig. 2B) shows the waveform of the envelope of the input signal to the RF amplifier 204 that is composed of nine channels of a CDMA signal (scaled by 3.6). The other graphs (Figs. 2D and 2E) show the envelope of the output from the RF amplifier 204. The middle graph (Fig. 2D) shows a conventional situation, when the VEC is disabled and only the voltage +B_{c} is supplied. Severe distortion of outputs above 80 Volts is noticeable. The lower graph (Fig. 2E) shows the situation when the FB-VEC 211 (shown in Fig. 2B) is operated. In the lower graph, the fast tracking of the change in the envelope amplitude above values of 80 Volts is noteworthy.

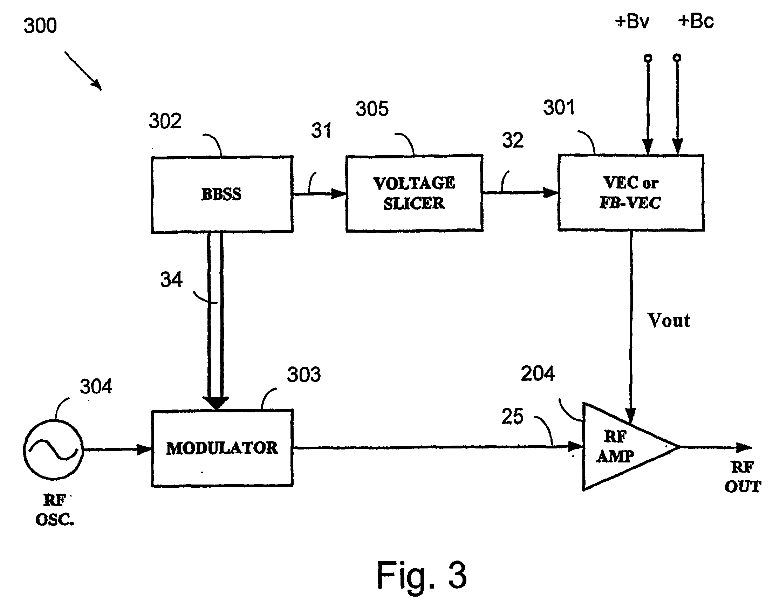

Fig. 3 is a block diagram of a circuit for controlling the supply voltage to the power amplifier when there is access to baseband signals, according to a preferred embodiment of the invention. The circuit 300 employs a VEC block 301, which may be either the basic VEC 202 without feedback (shown in Fig. 2B), or the FB-VEC (shown in Fig. 2B). The circuit 300 is implemented with access to the amplitude value of the Base Band Signal Source (BBSS) 302, at point 31. The RF power amplifier 204 should amplify RF signals with large peaks above its average value, as obtained from the Base Band Signal Source 302. The BBSS 302 outputs complex signals at point 34, which are input to an appropriate modulator 303 that is also fed by an RF sinewave from an RF oscillator 304. The BBSS 302 feeds the amplitude information that appears at point 31 into the Voltage Slicer 305. The Voltage Slicer 305 performs the same operation on a Base Band Signal, as the EES block 201 performs on an input RF signal: It outputs an excess signal ES at point 32 when the amplitude at point 31 exceeds the reference level L. The operations that follow are exactly as shown in Fig. 2A above.

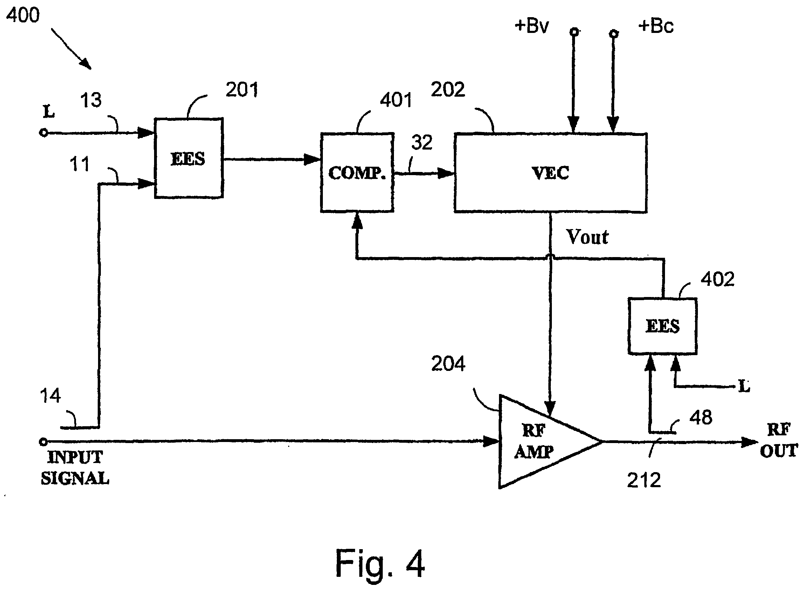

Fig. 4 is a block diagram of a circuit for controlling the enhanced supply voltage to the power amplifier by feeding back part of the RF amplifier output signal, rather than part of the EV, as shown in Fig. 2B. The circuit 400 is a refinement of the FB-VEC block 211, shown in Fig. 2B. Comparator 401 compares the output of the EES 201 with the output of an additional EES 402, that is coupled to the output (point 48) of the RF power amplifier 204, by a coupler 212. As shown in Fig. 2B above, the difference voltage at point 32, that appears at the output of the comparator 401, is fed into the VEC block 202. The fact that in this implementation the feedback loop includes also the RF power amplifier 204 is advantageous, since circuit 400 can potentially correct non-linearities of the RF power amplifier 204, as well.

According to another embodiment of the invention, the VEC is utilized to improve the efficiency of a power amplifier, in which the *Doherty configuration* is utilized (*Doherty configuration* is described, for example, in U.S. Patent 2,210,028, and in "RF Power Amplifiers for Wireless Communications", Artech House 1999, pp. 225-239 chapter 8, to Steve C. Cripps).

The Doherty *configuration* improves the efficiency of a power amplifier (hereinafter the MAIN amplifying circuitry), by introducing an additional amplifying circuitry (hereinafter the AUXILIARY amplifying circuitry), where the outputs of said amplifiers are coupled via a coupling circuitry (so called *Doherty coupling*). While the MAIN amplifying circuitry is continuously operative, the AUXILIARY amplifying circuitry is activated whenever the value of the input exceeds a predefined threshold (hereinafter called the *Doherty threshold*). In this fashion, by setting a proper coupling between the outputs of the amplifying circuitries, the operation of the MAIN amplifying circuitry is maintained in a fixed point of operation (i.e. operating with a constant output voltage).

Efficiency is substantially improved by allowing the MAIN amplifying circuitry to operate at its maximal output voltage (Vₘₐₓ) for all input signals having magnitude above the threshold. At this point of operation, the MAIN amplifier's efficiency is maximal, and this is maintained due to the *Doherty coupling.* This way, whenever the input signal exceeds a predefined value, the AUXILIARY amplifying circuitry is activated, and boosts the power output up to a factor of 2, without effecting the output voltage of the MAIN amplifying circuitry.

However, the voltage range, in which the *Doherty configuration* operates, is limited by the value of the threshold utilized to activate the AUXILIARY amplifying circuitry. It is, in fact, limited to approximately twice (factor of 2) the value of said threshold. More particularly, according to the prior art, the *Doherty configuration* is utilized up to the point where the currents of the MAIN amplifying circuitry and the AUXILIARY amplifying circuitry meet (i.e. the point at which each of the currents is equal to a value of Iₘₐₓ), and thus it is not a fully satisfactory solution in systems having a large peak-to-average ratio (crest factor).

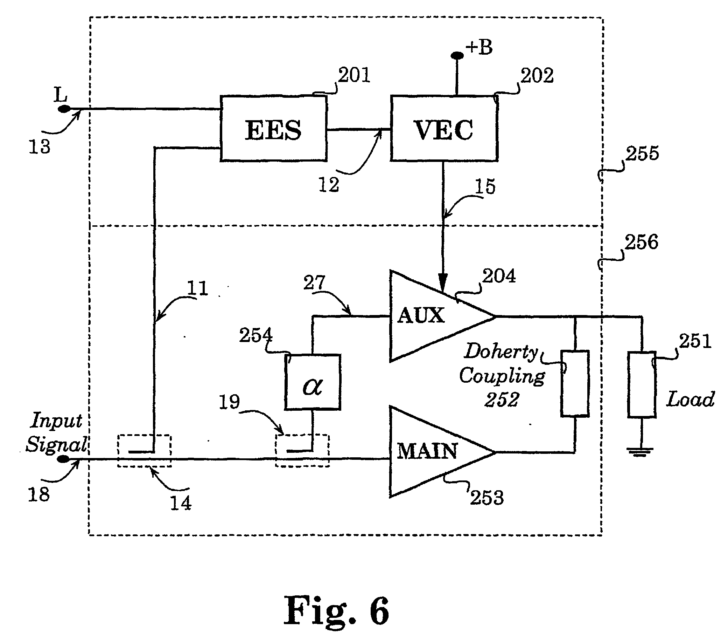

To overcome this limitation (factor of 2), the VEC is utilized, according to a preferred embodiment of the invention, in combination with the Doherty configuration, as schematically illustrated in Fig. 6. The system in Fig. 6 consists of an amplifying unit 256, and another unit 255, for detection of excess envelope signals, and for Voltage Enhancement (VE). The latter is utilized to enhance the power supply of the amplifying unit 256, whenever an excess envelope signal is detected, as will be described in details herein below.

The EES's output 12 drives the Voltage Enhancement Circuitry (VEC) 202, which enhances the power supplied to the amplifying circuitry 256, whenever an excess envelope signal is introduced on its input 12, and operates as an additional power supply to the amplifying circuitry 256. The input signal becomes an excess signal for magnitudes that are greater than the predetermined Reference Level (*L*). It should be noted that the predetermined Reference Level (*L*) that activates the voltage enhancement of the VEC 202 is greater than the *Doherty threshold*.

The amplifying circuitry 256 comprises two amplifiers, a MAIN amplifying circuitry 253, and an AUXILIARY amplifying circuitry 204. Those amplifiers are connected in a *Doherty configuration*, wherein the MAIN amplifying circuitry 253 is continuously operating, while the AUXILIARY amplifying circuitry 204 is activated only when power enhancement is received from the VEC 202, on 15.

The *Doherty configuration* is utilized to improve the efficiency, and as was explained hereinbefore, this is achieved by coupling the outputs of the amplifiers, 204 and 253, by the *Doherty coupler* 252. The functioning of the *Doherty coupler* 252 acts to reduce the impedance of the Load, as "seen" by the MAIN amplifying circuitry 253, as the value of the input signal 18 increases. This way, the power output is increased while keeping the output voltage of the MAIN amplifying circuitry constant. A *Doherty configuration* 256 is utilized to produce output voltage which exceeds the typical output voltage Vₘₐₓ, of the MAIN amplifying circuitry. The *Doherty configuration is* typically designed such that the AUXILIARY amplifying circuitry is activated to increase the output power whenever the input signal 18 exceeds an average input value. The voltage of the MAIN amplifying circuitry 253 typically reaches its maximal output voltage (Vₘₐₓ) when the AUXILIARY amplifying circuitry is activated. Increasing the input signal above the average input value will result in increasing the output voltage of the AUXILIARY amplifying circuitry, and also of the currents of both, the MAIN and AUXILIARY amplifiers.

The *Doherty* coupling circuitry 252 has a phase constant (i.e., a delay), typically of ^{π}/₂. Thus, the output voltages of the amplifying circuitries, 204 and 253, may have a phase difference, unless a compensating circuitry 254 is introduced at the input of one (or both of) the amplifying circuitries, 204 and 253. This compensating circuitry 254 affects the inputs of the amplifying circuitries, 204 and 253, to eliminate the phase difference caused by the coupling circuitry 252. The input of said compensating circuitry 254 is coupled from the input signal on 18 by utilizing a coupling circuitry 19.

However, the output voltage and the currents of the amplifiers are limited in the *Doherty configuration*. Typically, the output voltage of the AUXILIARY amplifying circuitry may be increased up to Vₘₐₓ, and the currents of the MAIN and AUXILIARY amplifying circuitries may be increased up to Iₘₐₓ each. According to the invention, the output voltage of the AUXILIARY amplifying circuitry, and the currents of both MAIN and AUXILIARY amplifying circuitries, in the *Doherty configuration* may now exceed the values of Vₘₐₓ and Iₘₐₓ, respectively, by utilizing the VEC to enhance the voltage supply to the AUXILIARY amplifying circuitry 204.

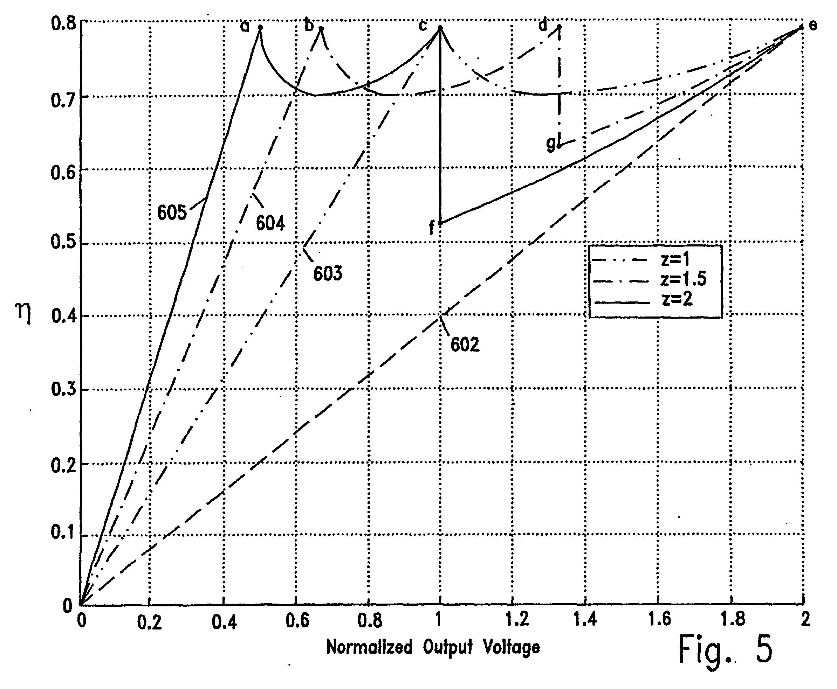

Fig. 5 illustrates the expected efficiency η versus the normalized output voltage at the load, as analyzed for various voltage enhancement values, according to a preferred embodiment of the invention. The curve 602 illustrates the linear efficiency achieved by a conventional Class B amplifier. As illustrated by curve 603, the efficiency is substantially improved when the *Doherty configuration* is conventionally utilized. The efficiency is further improved when the VEC 202 is utilized for enhancing the voltage supplied to the AUXILIARY amplifying circuitry of the *Doherty configuration* such that the voltage across the load increases beyond Vₘₐₓ, depending on the enhancement factor Z (the enhancement factor Z is defined as the ratio between the level of DC voltage that is supplied to a power amplifier for the maximal value of the excess input signal, and the level of DC voltage that is supplied to said power amplifier in the absence of an excess input signal). Curves 603, 604 and 605 illustrate the operation of the *Doherty configuration* for enhancement factors of Z=1 (no enhancement), Z=1.5 and Z=2, respectively. If Vₘₐₓ represents the maximum voltage across the load for a conventional *Doherty configuration*, in Fig. 5 curve 603 is normalized to 0.5Vₘₐₓ, curve 604 is normalized to 0.66Vₘₐₓ, and curve 603 is normalized to Vₘₐₓ.

In curve 603, point ***c*** represents the normalized voltage across the load for which the AUXILIARY amplifying circuitry begins to be active, and point ***e*** represents the normalized voltage across the load for which the AUXILIARY amplifying circuitry is fully active and contributes its maximum power to the load, without enhancement. In this case (with Z=1), the maximum voltage that can be obtained across the load is Vₘₐₓ.

In curve 604, point ***b*** represents the normalized voltage across the load for which the AUXILIARY amplifying circuitry begins to be active, and point ***d*** represents the normalized voltage across the load for which the AUXILIARY amplifying circuitry is fully active and contributes its maximum power to the load, without enhancement. At this point ***d*** the maximum voltage that can be obtained across the load is Vₘₐₓ. When an enhancement factor of Z=1.5 is applied, the efficiency η increases from point ***g***, along the curve to point ***e***. In this case, the maximum voltage that can be obtained across the load for Z=1.5 is 1.33Vₘₐₓ.

In curve 605, point ***a*** represents the normalized voltage across the load for which the AUXILIARY amplifying circuitry begins to be active, and point c represents the normalized voltage across the load for which the AUXILIARY amplifying circuitry is fully active and contributes its maximum power to the load, without enhancement. At this point ***c*** the maximum voltage that can be obtained across the load is Vₘₐₓ. When an enhancement factor of Z=2 is applied, the efficiency η increases from point ***f***, along the curve to point e. In this case, the maximum voltage that can be obtained across the load for Z=2 is 2Vₘₐₓ. Therefore, the enhancement of the voltage that is supplied to the AUXILIARY amplifying circuitry of the *Doherty configuration* allows obtaining output voltage levels, across the load, which are higher than Vₘₐₓ, (which of course, resulting in higher output power) depending on the value of the enhancement factor Z.

The above examples and description have of course been provided only for the purpose of illustration, and are not intended to limit the invention in any way. As will be appreciated by the skilled person, the invention can be carried out in a great variety of ways, employing more than one technique from those described above, all without exceeding the scope of the invention as defined in the appended claims.

## Claims

1. A method for improving the efficiency and the dynamic range of a power amplifier (204), comprising:
a) determining a reference level (L), above which at least a portion of the magnitude of an input signal (Vₑₙ(t)) being a modulated signal that is input to said power amplifier, or a baseband waveform that is used to generate said modulated signal, is defined as an excess input signal (ES);
b) continuously sampling said magnitude of said input signal, for detecting an excess input signal;
**characterized in that** it further comprises:
c) supplying a constant level of operating voltage (+B_{c}) to said power amplifier, if no excess input signal is detected, said constant level of operating voltage being sufficient to effectively amplify input signals (Vₑₙ(t)) having a magnitude below said reference level(L); and
d) whenever an excess input signal(ES) is detected, concurrently supplying a variable level (EV) of operating voltage to said power amplifier, said variable level of operating voltage essentially tracking the magnitude of said excess input signal, thereby supplying a variable increased level of operating voltage being sufficient to effectively amplify input signals having a magnitude above said reference level.

2. A method according to claim 1, further comprising:
a) coupling an automatic gain control circuit (209) to the input of said power amplifier, for controlling the magnitude of said input signal(s) (Vₑₙ(t))prior to amplification;
b) whenever an excess input signal (ES) is detected, sampling said excess input signal; and
c) compensating changes in the gain of said power amplifier (204) during the presence of said excess input signal by controlling the gain of said automatic gain control circuit, according to the samples of said excess input signal.

3. A method according to claim 1, wherein the level of operating voltage is supplied to the power amplifier (204) by performing the following steps:
a) providing a first voltage source (+B_{c}) for feeding said power amplifier;
b) providing a second voltage source (+Bᵥ) for additionally feeding said power amplifier whenever an excess input signal (ES) is detected;
c) connecting the voltage supply contact of said power amplifier to said second voltage source (+Bᵥ) through a variable impedance (203) and to said first voltage source (+B_{c}) through a further variable impedance (205);
d) whenever no excess input signal is detected, controlling said variable impedance to be in its high impedance state; and
e) whenever an excess input signal is detected, controlling said variable impedance to be in a low impedance state, said low impedance state being essentially equal to the value required to increase said second voltage source to a level capable of tracking the magnitude of said excess input signal.

4. A method according to claim 3, wherein a further power supply provides the second voltage source (+Bv) whenever an excess input signal is detected.

5. A method according to claim 1, wherein the level of operating voltage is supplied to the power amplifier (204) by performing the following steps:
a) providing a first voltage source (+B_{c}) for additionally feeding said power amplifier whenever no excess input signal (ES) is detected;
b) providing another voltage source (+Bᵥ) for feeding said power amplifier whenever an excess input signal is detected;
c) connecting the voltage supply contact of said power amplifier to said first voltage source(+B_{c}) through a variable impedance (205), and to said another voltage source (+Bᵥ) through a voltage amplifier (203), said variable impedance being capable of presenting a low resistance to DC and a high impedance for rapidly varying pulses;
d) whenever no excess input signal is detected, allowing said variable impedance to reach its lowest impedance; and
e) whenever an excess input signal is detected, allowing said variable impedance to reach its high impedance, and allowing said voltage amplifier to supply a voltage level, being higher than the voltage of said first voltage source, to said voltage supply contact of said power amplifier.

6. A method according to claim 3, wherein at least one of the variable impedances is a controllable impedance.

7. A method according to claim 3, wherein the variable impedance is an inductor or a diode.

8. A method according to claim 6, wherein the controllable impedance is a bipolar transistor or a FET.

9. A method according to claim 1, further comprising.
a) normalizing levels of operating voltage, supplied to said power amplifier (204), to corresponding predetermined levels (L) of the excess input signal (ES);
b) sampling the level of operating voltage supplied to said power amplifier;
c) generating a voltage difference by comparing the level of operating voltage with said predetermined levels of the excess input signal; and
d) using said voltage difference for operating a negative feedback loop for accurately controlling the operating voltage supplied to said power amplifier.

10. A method according to claim 1, further comprising:
a) normalizing levels of the excess input signal (ES) to corresponding predetermined levels of RF output signals, amplified by said power amplifier (204);
b) sampling the level of RF output signals, amplified by said power amplifier;
c) generating a voltage difference by comparing the sampled level of RF output signals with the levels of the excess input signal; and
d) using said voltage difference for operating a negative feedback loop for accurately controlling the operating voltage supplied to said power amplifier.

11. A method according to claim 1, wherein the level of DC voltage, supplied to the power amplifier (204), is controlled, using the baseband waveform (Vₑₙ(t)), by performing the following steps:
a) providing a modulator (303), fed by a baseband signal source (302) that outputs said baseband waveform, for generating a modulated input signal to said power amplifier;
b) providing a voltage slicer (305) for extracting an excess signal (ES) from the baseband waveform when the magnitude of the baseband waveform exceeds a reference level (L);
c) supplying a constant level of operating voltage (+B_{c}) to said power amplifier, if no excess baseband signal is detected, said constant level of operating voltage being sufficient to effectively amplify input signals, modulated with a baseband waveform having a magnitude below said reference level; and
d) supplying a variable increased level of operating voltage (+B_{c} + EV)to said power amplifier, whenever an excess baseband signal is detected, said increased level of operating voltage being sufficient to effectively amplify input signals, modulated with a baseband waveform having a magnitude above said reference level.

12. Apparatus for improving the efficiency and the dynamic range of a power amplifier (204), comprising:
a) a sampling circuit (201) for continuously sampling the magnitude of an input signal being a modulated signal that is input to said power amplifier, or of a baseband waveform that is used to generate said modulated signal, for detecting an excess input signal (ES) according to a predetermined reference level (L), above which at least a portion of said input signal is defined as the excess input signal; and
b) a power supply for supplying an operating voltage to said power amplifier;
**characterized in that** it further comprises:
c) a control circuit (202), operating in combination with said power supply, for causing said power supply to supply a constant level of operating voltage (+B_{c}) being sufficient to effectively amplify input signals (Vₑₙ(t)) having a magnitude below said reference level, to said power amplifier, if no excess input signal is detected, and to concurrently supply to said power amplifier, whenever an excess input signal is detected, a variable increased level of operating voltage (EV) that essentially tracks the magnitude of said excess input signal and is sufficient to effectively amplify input signals having a magnitude above said reference level.

13. Apparatus according to claim 12, further comprising:
a) an automatic gain control circuit (209), coupled to the input of said power amplifier (204), for controlling the magnitude of said input signal(s) (Vₑₙ(t)) prior to amplification;
b) circuitry (201) for sampling said excess input signal (ES); and
c) a control circuitry (202), for compensating changes in the gain of said power amplifier during the presence of said excess input signal by controlling the gain of said automatic gain control circuit, according to the samples of said excess input signal.

14. Apparatus according to claim 12, comprising:
a) a first voltage source (+B_{c}) for feeding said power amplifier;
b) a second voltage source (+Bᵥ) for feeding said power amplifier whenever an excess input signal (ES) is detected;
c) a variable impedance (203) connected between the voltage supply input of said power amplifier and said second voltage source;
d) a further variable impedance (205) connected between the voltage supply input of said power amplifier and said first voltage source (+B_{c}); and
e) a control circuit (202) for controlling said variable impedance to be in its high impedance state whenever no excess input signal is detected, and to be in a low impedance state whenever an excess input signal is detected, said low impedance state being essentially equal to the value required to increase said second voltage source to a level capable of tracking the magnitude of said excess input signal.

15. Apparatus according to claim 12, comprising:
a) a first voltage source (+B_{c}) for feeding said power amplifier (204);
b) a second voltage source (+Bᵥ) for additionally feeding said power amplifier whenever an excess input signal is detected;
c) a voltage amplifier (203) connected between the voltage supply contact of said power amplifier and said second voltage source, for supplying a voltage level, being higher than the voltage of said first voltage source, to said voltage supply contact of said power amplifier; and
d) a control circuit (202), for controlling said voltage amplifier to supply a voltage level, being higher than the voltage of said first voltage source, to said voltage supply contact of said power amplifier, whenever no excess input signal is detected.

16. Apparatus according to claim 14 or 15, wherein a further power supply provides the second voltage source (+Bv) whenever an excess input signal is detected .

17. Apparatus according to claim 14, in which the variable impedance is a controllable impedance.

18. Apparatus according to claim 14, in which the variable impedance is an inductor or a diode.

19. Apparatus according to claim 17, in which the controllable impedance is a bipolar transistor or a FET.

20. Apparatus according to claim 12, further comprising:
a) a sampling circuit for sampling the level of operating voltage supplied to said power amplifier (204);
b) a comparator (210) for generating a voltage difference by comparing the sampled level of operating voltage (vₒᵤₜ(t))_supplied to said power amplifier, with the level of the excess input signal (ES); and
c) a negative feedback loop for accurately controlling the operating voltage supplied to said power amplifier, by using said voltage difference.

21. Apparatus according to claim 12, further comprising:
a) a sampling circuit (402) for sampling the level of RF output signals, amplified by said power amplifier;
b) a comparator (401) for generating a voltage difference by comparing between the sampled level of RF output signals, amplified by said power amplifier (204), with the level of the excess input signal (ES); and
c) a negative feedback loop for accurately controlling the operating voltage supplied to said power amplifier, by using said voltage difference.

22. Apparatus according to claim 12, comprising:
a) a modulator (303) for generating a modulated signal that is input to the power amplifier (204);
b) a baseband signal source (302) for generating a baseband waveform that is input to said modulator;
c) a voltage slicer (305) for extracting an excess input signal (ES) from the baseband waveform when the magnitude of the baseband waveform exceeds a reference level (L);
d) a power supply for supplying an operating voltage to said power amplifier; and
e) a control circuit (300), operating in combination with said power supply, for causing said power supply to supply a constant level (+B_{c}) of operating voltage being sufficient to effectively amplify input signals having a magnitude below said reference level, to said power amplifier, if no excess input signal is detected, and to supply a variable increased level (+B_{c} + EV) of operating voltage being sufficient to effectively amplify input signals having a magnitude above said reference level, to said power amplifier, whenever an excess input signal is detected.

23. A method according to claim 1, wherein the power amplifier is the auxiliary amplifying circuitry (256) of a *Doherty configuration.*

24. A method according to claim 23, comprising:
a) providing a *Doherty configuration* consisting of an auxiliary amplifier (204) directly connected to a load (251), and a main amplifier (253) coupled to said load through a *Doherty coupler* (252);
b) determining a reference level (L), above which at least a portion of the magnitude of an input signal (18) being a modulated signal that is input to said power amplifier, or a baseband waveform that is used to generate said modulated signal, is defined as an excess input signal (ES) such that said reference level is essentially equal to the level of the input signal that causes the main (255) and auxiliary amplifier (256) circuitries to output essentially the same power into the load, thereby reaching the maximal output power level under said DC operating voltage;
c) continuously sampling said magnitude of said input signal, for detecting an excess input signal;
d) continuously amplifying the input signal with said main amplifier by supplying a constant operating voltage (B_{c}) to said main amplifier circuitry;
e) as long as no excess input signal is detected, amplifying the input signal by the auxiliary amplifier circuitry by supplying, to said auxiliary amplifier, the same DC operating voltage supplied to said main amplifier; and
f) whenever an excess input signal is detected, concurrently supplying a variable increased level of DC operating voltage (B_{c} + EV) to said auxiliary amplifying circuitry, said enhanced level of operating voltage being sufficient to effectively amplify input signals having said magnitude above said reference level.

25. Apparatus according to claim 12, in which the power amplifier is an auxiliary amplifying circuitry (256) used in a *Doherty configuration*, the output of said auxiliary amplifying circuitry being directly connected to a load (251) and being operated in combination with a main amplifier (253) that is coupled to said load through a *Doherty coupler* (252), the input of said auxiliary amplifying circuitry being coupled to the input of said main amplifier through a phase shifting circuitry (254) having essentially similar phase shift to the phase shift that is introduced by said *Doherty coupler.*

## Patentansprüche

1. Ein Verfahren zur Erhöhung des Wirkungsgrads und des dynamischen Bereichs eines Leistungsverstärkers (204), das folgendes umfasst:
a) Bestimmung eines Bezugspegels (L), über den mindestens ein Abschnitt der Amplitude eines Eingabesignals (V_{*en*}(t)), das ein moduliertes Signal ist, das in den Leistungsverstärker eingegeben wird, oder eine Basisband-Wellenform, die verwendet wird, um das modulierte Signal zu erzeugen, als ein überschüssiges Eingabesignal (ES) bestimmt wird;
b) das kontinuierliche Abtasten der Amplitude des Eingabesignals zur Erfassung eines überschüssigen Eingabesignals;
**dadurch gekennzeichnet, dass** es weiterhin folgendes umfasst:
c) die Zuführung eines konstanten Pegels der Betriebsspannung (+B_{c}) an den Leistungsverstärker, wenn kein überschüssiges Eingabesignal erfasst wird, wobei der konstante Pegel der Betriebsspannung ausreichend ist, um wirksam Eingabesignale (Vₑₙ(t)) zu verstärken, die eine Amplitude haben, die unterhalb des Bezugspegels (L) liegt; und
d) wann immer ein überschüssiges Eingabesignal (ES) erfasst wird, die simultane Zuführung eines variablen Pegels (EV) der Betriebsspannung an den Leistungsverstärker, wobei der variable Pegel der Betriebsspannung im wesentlichen der Amplitude des überschüssigen Eingabesignals folgt, wodurch ein variabler erhöhter Pegel der Betriebsspannung zugeführt wird, der ausreichend ist, um wirksam Eingabesignale zu verstärken, die eine Amplitude über den Bezugspegel haben.

2. Ein Verfahren gemäß Anspruch 1, das weiterhin folgendes umfasst:
a) das Verbinden einer Schaltung (209) für die automatische Verstärkungsregelung an die Eingabe des Leistungsverstärkers, zur Steuerung der Amplitude des Eingabesignals bzw. der Eingabesignale (Vₑₙ(t)) vor der Verstärkung;
b) wann immer ein überschüssiges Eingabesignal (ES) erfasst wird, das Abtasten des überschüssigen Eingabesignals; und
c) die Kompensierung von Veränderungen in der Verstärkung des Leistungsverstärkers (204) während der Anwesenheit des überschüssigen Eingabesignals, indem die Verstärkung der Schaltung mit automatischer Verstärkungsregelung in Übereinstimmung mit den Abtastungen des überschüssigen Eingabesignals gesteuert wird.

3. Ein Verfahren gemäß Anspruch 1, worin der Pegel der Betriebsspannung dem Leistungsverstärker (204) zugeführt wird, indem die folgenden Schritte durchgeführt werden:
a) die Bereitstellung einer ersten Spannungsquelle (+B_{c}) zur Speisung des Leistungsverstärkers;
b) die Bereitstellung einer zweiten Spannungsquelle (+Bᵥ) für die zusätzliche Speisung des Leistungsverstärkers, wann immer ein überschüssiges Eingabesignal (ES) erfasst wird;
c) die Verbindung des Spannungsversorgungsanschlusses des Leistungsverstärkers mit der zweiten Spannungsquelle (+Bᵥ) durch eine variable Impedanz (203) und mit der ersten Spannungsversorgung (+B_{c}) durch eine weitere variable Impedanz (205);
d) wann immer kein überschüssiges Eingabesignal erfasst wird, die Steuerung der variablen Impedanz, um diese in ihrem Zustand mit hoher Impedanz zu führen; und
e) wann immer ein überschüssiges Eingabesignal erfasst wird, die Steuerung der variablen Impedanz, um in einem Zustand mit niedriger Impedanz zu sein, wobei der Zustand mit niedriger Impedanz im wesentlichen gleich mit dem Wert ist, der erforderlich ist, um die zweite Spannungsquelle auf einen Pegel zu erhöhen, der in der Lage ist, der Amplitude des überschüssigen Eingabesignals zu folgen.

4. Ein Verfahren gemäß Anspruch 3, worin eine weitere Energieversorgung die zweite Spannungsquelle (+Bᵥ) bereitstellt, wann immer ein überschüssiges Eingabesignal erfasst wird.

5. Ein Verfahren gemäß Anspruch 1, worin der Pegel der Betriebsspannung dem Leistungsverstärker (204) zugeführt wird, indem die folgenden Schritte durchgeführt werden:
a) die Bereitstellung einer ersten Spannungsquelle (+B_{c}) für die zusätzliche Speisung des Leistungsverstärkers, wann immer kein überschüssiges Eingabesignal (ES) erfasst wird;
b) die Bereitstellung einer anderen Spannungsquelle (+Bᵥ) für die Speisung des Leistungsverstärkers, wann immer ein überschüssiges Eingabesignal erfast wird;
c) die Verbindung des Spannungsversorgungsanschlusses des Leistungsverstärkers an die erste Spannungsquelle (+B_{c}) durch eine variable Impedanz (205) und an die andere Spannungsquelle (+Bᵥ) durch einen Spannungsverstärker (203), worin die variable Impedanz in der Lage ist, eine niedrige Impedanz bei einem Gleichstrom zu zeigen, und eine hohe Impedanz für schnell variable Pulse;
d) wann immer sein überschüssiges Eingabesignal erfasst wird, das Gestatten, dass die variable Impedanz ihre niedrigste Impedanz erreicht; und
e) wann immer ein überschüssiges Eingabesignal erfasst wird, das Gestatten, dass die variable Impedanz ihre höchste Impedanz erreicht, und das Gestatten, dass der Spannungsverstärker einen Spannungspegel, der höher ist als jener der Spannung der ersten Spannungsquelle, an den Spannungsversorgungsanschluss des Leistungsverstärkers zuführt.

6. Ein Verfahren gemäß Anspruch 3, worin mindestens eine der variablen Impedanzen eine steuerbare Impedanz ist.

7. Ein Verfahren gemäß Anspruch 3, worin die variable Impedanz eine Drosselspule oder eine Diode ist.

8. Ein Verfahren gemäß Anspruch 6, worin die steuerbare Impedanz ein bipolarer Transistor oder ein FET ist.

9. Ein Verfahren gemäß Anspruch 1, das weiterhin folgendes umfasst:
a) Normalisierung der Pegel der Betriebsspannung, die dem Leistungsverstärker (204) zugeführt werden, auf entsprechende vorbestimmte Pegel (L) des überschüssigen Eingabesignals (ES);
b) das Abtasten des Pegels der Betriebsspannung, die dem Leistungsverstärker zugeführt wird;
c) das Erzeugen einer Spannungsdifferenz, indem der Pegel der Betriebsspannung mit den vorbestimmten Pegeln des überschüssigen Eingabesignals verglichen wird; und
d) die Verwendung der Spannungsdifferenz zum Betreiben einer negativen Rückkopplungsschleife zur genauen Steuerung der Betriebsspannung, die dem Leistungsverstärker zugeführt wird.

10. Ein Verfahren gemäß Anspruch 1, das weiterhin folgendes umfasst:
a) die Normalisierung der Pegel des überschüssigen Eingabesignals (ES) auf entsprechende vorbestimmte Pegel von HF-Ausgabesignalen, die durch den Leistungsverstärker (204) verstärkt werden;
b) das Abtasten des Pegels der HF-Ausgabesignale, die durch den Leistungsverstärker verstärkt werden;
c) das Erzeugen einer Spannungsdifferenz durch den Vergleich des abgetasteten Pegels der HF-Ausgabesignale mit den Pegeln des überschüssigen Eingabesignals; und
d) die Verwendung der Spannungsdifferenz zum Betreiben einer negativen Rückkopplungsschleife für die genaue Steuerung der Betriebsspannung, die dem Leistungsverstärker zugeführt wird.

11. Ein Verfahren gemäß Anspruch 1, worin der Pegel der Gleichspannung, die den Leistungsverstärker (204) zugeführt wird, gesteuert wird, indem die Basisband-Wellenform (Vₑₙ(t)) verwendet wird, indem die folgenden Schritte durchgeführt werden:
a) die Bereitstellung eines Modulators (303), der durch eine Basisband-Signalquelle (302) gespeist wird, die die Basisband-Wellenform ausgibt, zur Erzeugung eines modulierten Eingabesignals an den Leistungsverstärker;
b) die Bereitstellung eines Spannungsschneiders (305) zur Extraktion eines überschüssigen Signals (ES) aus der Basisband-Wellenform, wenn die Amplitude der Basisband-Wellenform einen Bezugspegel (L) überschreitet;
c) die Zuführung eines konstanten Pegels der Betriebsspannung (+B_{c}) an den Leistungsverstärker, wenn kein überschüssiges Basisband-Signal erfasst wird, wobei der konstante Pegel der Betriebsspannung ausreichend ist, um wirksam Eingabesignale zu verstärken, die mit einer Basisband-Wellenform moduliert sind, die eine Amplitude unterhalb des Bezugspegels hat; und
d) die Zuführung eines variablen erhöhten Pegels der Betriebsspannung (+B_{c} +EV) an den Leistungsverstärker, wann immer ein überschüssiges Basisband-Signal erfasst wird, wobei der erhöhte Pegel der Betriebsspannung ausreichend ist, um wirksam Eingabesignale zu verstärken, die mit einer Basisband-Wellenform moduliert sind, die eine Amplitude oberhalb des Bezugspegels hat.

12. Vorrichtung zur Verbesserung des Wirkungsgrads des dynamischen Bereichs eines Leistungsverstärkers (204), die folgendes umfasst:
a) eine Abtastschaltung (201) für die kontinuierliche Abtastung der Amplitude eines Eingabesignals, das ein moduliertes Signal ist, das in den Leistungsverstärker eingegeben wird, oder einer Basisband-Wellenform, die verwendet wird, um das modulierte Signal zu erzeugen, zur Erfassung eines überschüssigen Eingabesignals (ES) in Übereinstimmung mit einem vorbestimmten Bezugspegel (L), über den mindestens ein Teil des Eingabesignals als das überschüssige Eingabesignal definiert ist; und
b) eine Energieversorgung, für die Zuführung einer Betriebsspannung an den Leistungsverstärker;
**dadurch gekennzeichnet, dass** sie folgendes umfasst:
c) eine Steuerschaltung (202), die zusammen mit der Energieversorgung arbeitet, um zu bewirken, dass die Energieversorgung einen konstanten Pegel der Betriebsspannung (+B_{c}), der ausreichend ist, um wirksam Eingabesignale (Vₑₙ(t)) zu verstärken, die eine Amplitude unterhalb des Bezugspegels haben, an den Leistungsverstärker zuführt, wenn kein überschüssiges Eingabesignal erfasst wird, und um simultan dem Leistungsverstärker, wann immer ein überschüssiges Eingabesignal erfasst wird, einen variablen erhöhten Pegel der Betriebsspannung (EV) zuzuführen, der im wesentlichen der Amplitude des überschüssigen Eingabesignals folgt und der ausreichend ist, um wirksam Eingabesignale zu verstärken, die eine Amplitude oberhalb des Bezugspegels haben.

13. Vorrichtung gemäß Anspruch 12, die weiterhin folgendes umfasst:
a) eine Schaltung (209) mit automatischer Verstärkungsregelung, die mit der Eingabe des Leistungsverstärkers (204) gekoppelt ist, zur Steuerung der Amplitude des Eingabesignals bzw. der Eingabesignale (Vₑₙ(t)) vor der Verstärkung;
b) eine Schaltung (201) zur Abtastung des überschüssigen Eingabesignals (ES); und
c) eine Steuerschaltung (202) zur Kompensierung von Änderungen in der Verstärkung des Leistungsverstärkers während der Anwesenheit des überschüssigen Eingabesignals, indem die Verstärkung der Schaltung mit automatischer Verstärkungsregelung gesteuert wird, und zwar in Übereinstimmung mit den Abtastungen des überschüssigen Eingabesignals.

14. Vorrichtung gemäß Anspruch 12, die folgendes umfasst:
a) eine erste Spannungsquelle (+B_{c}) für die Speisung des Leistungsverstärkers;
b) eine zweite Spannungsquelle (+Bᵥ) für die Speisung des Leistungsverstärkers, wann immer ein überschüssiges Eingabesignal (ES) erfasst wird;
c) eine variable Impedanz (203), die zwischen der Spannungsversorgungseingabe des Leistungsverstärkers und der zweiten Spannungsquelle verbunden ist; und
d) eine weitere variable Impedanz (205), die zwischen der Spannungsversorgungeingabe des Leistungsverstärkers und der ersten Spannungsquelle (+B_{c}) verbunden ist; und
e) eine Steuerschaltung (202) zur Steuerung der variablen Impedanz, um diese in ihrem Zustand mit hoher Impedanz zu führen, wann immer kein überschüssiges Eingabesignal erfasst wird, und um diese in einem Zustand mit niedriger Impedanz zu führen, wann immer ein überschüssiges Eingabesignal erfasst wird, wobei der Zustand mit niedriger Impedanz im wesentlichen gleich mit dem Wert ist, der erforderlich ist, um die zweite Spannungsquelle auf einem Pegel zu erhöhen, der in der Lage ist, der Amplitude des überschüssigen Eingabesignals zu folgen.

15. Vorrichtung gemäß Anspruch 12, die weiterhin folgendes umfasst:
a) eine erste Spannungsquelle (+B_{c}) für die Speisung des Leistungsverstärkers (204);
b) eine zweite Spannungsquelle (+Bᵥ) für die zusätzliche Speisung des Leistungsverstärkers, wann immer ein überschüssiges Eingabesignal erfasst wird;
c) ein Spannungsverstärker, der zwischen dem Spannungsversorgunganschluss des Leistungsverstärkers und der zweiten Spannungsquelle verbunden ist, für die Zuführung eines Spannungspegels, der höher als die Spannung der ersten Spannungsquelle ist, an den Spannungsversorgungsanschluss des Leistungsverstärkers; und
d) eine Steuerschaltung (202) für die Steuerung des Spannungsverstärkers, um einen Spannungspegel zuzuführen, der höher als die Spannung der ersten Spannungsquelle ist, an den Spannungsversorgungsanschluss des Leistungsverstärkers, wann immer kein überschüssiges Eingabesignal erfasst wird.

16. Vorrichtung gemäß Anspruch 14 oder 15, worin eine weitere Energieversorgung die zweite Spannungsquelle bereitstellt, wann immer ein überschüssiges Eingabesignal erfasst wird.

17. Vorrichtung gemäß Anspruch 14, in der die variable Impedanz eine steuerbare Impedanz ist.

18. Vorrichtung gemäß Anspruch 14, in der die variable Impedanz eine Drosselspule oder eine Diode ist.

19. Vorrichtung gemäß Anspruch 17, in der die steuerbare Impedanz ein bipolarer Transistor oder ein FET ist.

20. Vorrichtung gemäß Anspruch 12, die weiterhin folgendes umfasst:
a) eine Abtastschaltung für die Abtastung des Pegels der Betriebsspannung, die dem Leistungsverstärker (204) zugeführt wird,
b) einem Komparator (210) zur Erzeugung einer Spannungsdifferenz durch den Vergleich des abgetasteten Pegels der Betriebsspannung (Vₒᵤₜ(t)), die dem Leistungsverstärker zugeführt wird, mit dem Pegel des überschüssigen Eingabesignals (ES); und
c) eine negative Rückkopplungsschleife zur genauen Steuerung der Betriebsspannung, die dem Leistungsverstärker zugeführt wird, indem die Spannungsdifferenz verwendet wird.

21. Vorrichtung gemäß Anspruch 12, die weiterhin folgendes umfasst:
a) eine Abtastschaltung (402) zur Abtastung des Pegels des HF-Ausgabesignals, das durch den Leistungsverstärker verstärkt wird;
b) einen Komparator (401) zur Erzeugung einer Spannungsdifferenz durch den Vergleich des abgetasteten Pegels des HF-Ausgabesignals, das durch den Leistungsverstärker (204) verstärkt wird, mit dem Pegel des überschüssigen Eingabesignals (ES); und
c) eine negative Rückkopplungsschleife zur genauen Steuerung der Betriebsspannung, die dem Leistungsverstärker zugeführt wird, indem die Spannungsdifferenz verwendet wird.

22. Vorrichtung gemäß Anspruch 12, die weiterhin folgendes umfasst:
a) einen Modulator (303) zur Erzeugung eines modulierten Signals, das in den Leistungsverstärker (204) eingegeben wird;
b) eine Basisband-Signalquelle (302) zur Erzeugung einer Basisband-Wellenform, die in den Modulator eingegeben wird;
c) einen Spannungsschneider (305) zur Extraktion eines überschüssigen Eingabesignals (ES) aus der Basisband-Wellenform, wenn die Amplitude der Basisband-Wellenform einen Bezugspegel (L) überschreitet;
d) eine Energieversorgung für die Zuführung einer Betriebsspannung an den Leistungsverstärker; und
e) eine Steuerschaltung (300), die zusammen mit der Energieversorgung arbeitet, um zu bewirken, dass die Energieversorgung einen konstanten Pegel (+B_{c}) der Betriebsspannung, der ausreichend ist, um wirksam Eingabesignale zu verstärken, die eine Amplitude unterhalb des Bezugspegels haben, an den Leistungsverstärker zuführt, wenn kein überschüssiges Eingabesignal erfasst wird, und um einen variablen erhöhten Pegel (+B_{c} +EV) der Betriebsspannung zuzuführen, der ausreichend ist, um wirksam Eingabesignale zu verstärken, die eine Amplitude über den Bezugspegel haben, an den Leistungsverstärker, wann immer ein überschüssiges Eingabesignal erfasst wird.

23. Ein Verfahren gemäß Anspruch 1, worin der Leistungsverstärker die Hilfsverstärkerschaltung (256) mit einer *Doherty-Konfiguration.*

24. Ein Verfahren gemäß Anspruch 23, das folgendes umfasst:
a) die Bereitstellung einer *Doherty-Konfiguration,* die aus einem Hilfsverstärker (204), der direkt mit einer Last (251) verbunden ist, und einem Hauptverstärker (253) besteht, der durch einen *Doherty-Koppler* (252) mit der Last verbunden ist;
b) die Bestimmung eines Bezugspegel (L), über den mindestens ein Teil der Amplitude eines Eingabesignals (18), das ein moduliertes Signal ist, das der Eingabe des Leistungsverstärkers zugeführt wird, oder eine Basisband-Wellenform, die verwendet wird, um das modulierte Signal zu erzeugen, als ein überschüssiges Eingabesignal (ES) definiert ist, und zwar derart dass der Bezugspegel im wesentlichen gleich mit dem Pegel des Eingabesignals ist, was bewirkt, dass die Haupt- (255) und Hilfsverstärker (256) Schaltungen im wesentlichen dieselbe Leistung an die Last ausgeben, wobei der maximale Ausgabeleistungspegel unter der DC-Betriebsspannung erreicht wird;
c) das kontinuierliche Abtasten der Amplitude des Eingabesignals zur Erfassung eines überschüssigen Eingabesignals;
d) das kontinuierliche Verstärken des Eingabesignals mit dem Hauptverstärker, indem eine konstante Betriebsspannung (B_{c}) der Hauptverstärkerschaltung zugeführt wird;
e) solange kein überschüssiges Eingabesignal erfasst wird, das Verstärken des Eingabesignals durch die Hilfsverstärkerschaltung durch die Zuführung an den Hilfsverstärker derselben DC-Betriebsspannung, die den Hauptverstärker zugeführt wird; und
f) wann immer ein überschüssiges Eingabesignal erfasst wird, die simultane Zuführung eines variablen erhöhten Pegels der DC-Betriebsspannung (B_{c} + EV) an die Hilfsverstärkerschaltung, wobei der verbesserte Pegel der Betriebsspannung ausreichend ist, um wirksam Eingabesignale zu verstärken, die die Amplitude oberhalb des Bezugspegels haben.

25. Vorrichtung gemäß Anspruch 12, in der der Leistungsverstärker eine Hilfsverstärkerschaltung (256) ist, die in einer *Doherty-Konfiguration* verwendet wird, wobei die Ausgabe der Hilfsverstärkerschaltung direkt mit einer Last (251) verbunden ist und zusammen mit einem Hauptverstärker (253) betrieben wird, der mit der Last durch einen *Doherty-Koppler* (252) gekoppelt ist, wobei die Eingabe der Hilfsverstärkerschaltung durch eine Phasenverschiebungsschaltung (254) mit der Eingabe des Hauptverstärkers gekoppelt ist, die im wesentlichen eine ähnliche Phasenverschiebung zur Phasenverschiebung hat, die durch den *Doherty-Koppler* eingeführt wird.

## Revendications

1. Un procédé pour améliorer l'efficacité et la plage dynamique d'un amplificateur de puissance (204), comprenant :
a) la détermination de niveau de référence (L), au-dessus duquel au moins une partie de l'amplitude d'un signal d'entrée (Ven(t)), qui est un signal modulé introduit audit amplificateur de puissance, ou une forme d'onde de bande de base utilisée pour générer ledit signal modulé, est définie en tant que signal d'entrée excessif (ES) ;
b) l'échantillonnage continu de ladite amplitude dudit signal d'entrée, afin de détecter un signal d'entrée excessif;
**caractérisé en ce qu'**il comprend en outre :
c) la fourniture d'un niveau constant de tension de fonctionnement (+Bc) audit amplificateur de puissance, si aucun signal d'entrée excessif n'est détecté, ledit niveau constant de tension de fonctionnement étant suffisant pour amplifier efficacement des signaux d'entrée (Ven(t)) ayant une amplitude inférieure audit niveau de référence (L) ; et
d) si un signal d'entrée excessif (ES) est détecté, fournir simultanément un niveau variable (EV) de tension de fonctionnement audit amplificateur de puissance, ledit niveau variable de tension de fonctionnement poursuivant essentiellement l'amplitude dudit signal d'entrée excessif, de manière à fournir un niveau augmenté variable de tension de fonctionnement, qui soit suffisant pour amplifier efficacement les signaux d'entrée d'une amplitude supérieure audit niveau de référence.

2. Un procédé selon la revendication 1, comprenant en outre :
a) le couplage d'un circuit de commande automatique de gain (209) à l'entrée dudit amplificateur de puissance, pour commander l'amplitude du ou desdits signaux d'entrée (Ven(t)) avant de procéder à l'amplification ;
b) si l'on détecte un signal d'entrée excessif (ES), l'échantillonnage dudit signal d'entrée excessif ; et
c) la compensation des changements intervenant dans le gain dudit amplificateur de puissance (204) durant la présence dudit signal d'entrée excessif, par le biais d'une commande du gain dudit circuit de commande automatique de gain, selon les échantillons dudit signal d'entrée d'excès.

3. Un procédé selon la revendication 1, dans lequel le niveau de tension de fonctionnement est fourni à l'amplificateur de puissance (204) en effectuant les étapes suivantes, consistant à :
a) fournir une première source de tension (+Bc) pour alimenter ledit amplificateur de puissance ;
b) fournir une deuxième source de tension (+Bv) pour additionnellement alimenter ledit amplificateur de puissance si un signal d'entrée excessif (ES) est détecté ;
c) connecter le contact d'alimentation de tension dudit amplificateur de puissance, à ladite deuxième source de tension (+Bv), par l'intermédiaire d'une impédance variable (203), et à ladite première source de tension (+Bc), par l'intermédiaire d'une autre impédance variable (205) ;
d) si aucun signal d'entrée excessif n'est détecté, commander ladite impédance variable pour qu'elle se trouve à son état l'impédance haute ; et
e) si un signal d'entrée excessif est détecté, commander ladite impédance variable pour qu'elle soit en un état d'impédance basse, ledit état d'impédance basse étant essentiellement égal à la valeur nécessaire pour augmenter ladite deuxième source de tension, pour la porter à un niveau capable de poursuivre l'amplitude dudit signal d'entrée excessif.

4. Un procédé selon la revendication 3, dans lequel une alimentation de tension supplémentaire fournit la deuxième source de tension (+Bv), si un signal d'entrée excessif est détecté.

5. Un procédé selon la revendication 1, dans lequel le niveau de tension de fonctionnement est fourni à l'amplificateur de puissance (204) en exécutant les étapes suivantes :
a) fourniture d'une première source de tension (+Bc), pour additionnellement alimenter ledit amplificateur de puissance si aucun signal d'entrée excessif (ES) n'est détecté ;
b) fourniture d'une autre source de tension (+Bv), pour alimenter ledit amplificateur de puissance si un signal d'entrée excessif est détecté ;
c) connection du contact d'alimentation en tension dudit amplificateur de puissance, à ladite première source de tension (+Bv), par l'intermédiaire d'une impédance variable (205), et à ladite autre source de tension (+Bv), par l'intermédiaire d'un amplificateur de tension (203), ladite impédance variable étant capable de présenter une faible résistance à un courant continu CC et une haute impédance pour rapidement faire varier les impulsions ;
d) si aucun signal d'entrée excessif n'est détecté, laisser ladite impédance variable atteindre son impédance de valeur minimale ; et
e) si un signal d'entrée excessif est détecté, permettre à ladite impédance variable d'atteindre sa haute l'impédance, et laisser ledit amplificateur de tension alimenter un niveau de tension supérieur à la tension de ladite première source de tension, audit contact d'alimentation de tension dudit amplificateur de puissance.

6. Un procédé selon la revendication 3, dans lequel au moins l'une des impédances variables est une l'impédance pouvant être commandée.

7. Un procédé selon la revendication 3, dans lequel l'impédance variable est une inductance ou une diode.

8. Un procédé selon la revendication 6, dans lequel l'impédance pouvant être commandée est un transistor bipolaire ou un transistor à effet de champ FET.

9. Un procédé selon la revendication 1, comprenant en outre :
a) la normalisation des niveaux de tension de fonctionnement, fournie audit amplificateur de puissance (204), à des niveaux (L) prédéterminés correspondants du signal d'entrée excessif (ES) ;
b) l'échantillonnage du niveau de tension de fonctionnement fourni audit amplificateur de puissance ;
c) la génération d'une différence de tension, par comparaison du niveau de tension de fonctionnement audits niveaux prédéterminés du signal d'entrée excessif ; et
d) l'utilisation de ladite différence de tension pour actionner une boucle à réaction négative pour commander de façon précise la tension de fonctionnement fournie audit amplificateur de puissance.

10. Un procédé selon la revendication 1, comprenant en outre :
a) la normalisation des niveaux du signal d'entrée excessif (ES) à des niveaux prédéterminés correspondants de signaux de sortie de radio fréquence RF, amplifiés par ledit amplificateur de puissance (204) ;
b) l'échantillonnage du niveau des signaux de sortie RF, amplifiés par ledit amplificateur de puissance ;
c) la génération d'une différence de tension, par comparaison du niveau échantillonné des signaux de sortie RF aux niveaux du signal d'entrée excessif ; et
d) l'utilisation de ladite différence de tension pour actionner une boucle à réaction négative, afin de commander de façon précise la tension de fonctionnement fournie audit amplificateur de puissance.

11. Un procédé selon la revendication 1, dans lequel le niveau de tension CC fourni à l'amplificateur de puissance (204) est commandé par utilisation de la forme d'onde de bande de base (Ven(t)), en exécutant les étapes suivantes :
a) fourniture d'un modulateur (303), alimenté par une source de signal de bande de base (302) produisant ladite forme d'onde de bande de base, afin de générer un signal d'entrée modulé audit amplificateur de puissance ;
b) fourniture d'un limiteur de tension à seuil (305), pour extraire un signal excessif (ES) de la forme d'onde de bande de base, lorsque l'amplitude de la forme d'onde de bande de base dépasse un niveau de référence (L) ;
c) fourniture d'un niveau constant de tension de fonctionnement (+Bc) audit amplificateur de puissance, si aucun signal de bande de base excessif n'est détecté, ledit niveau constant de tension de fonctionnement étant suffisant pour efficacement amplifier des signaux d'entrée, ayant été modulés avec une forme d'onde de bande de base d'une amplitude inférieure audit niveau de référence ; et
d) fourniture d'un niveau augmenté variable de tension de fonctionnement (+Bc + EV) audit amplificateur de puissance, si un signal de bande de base excessif est détecté, ledit niveau augmenté de tension de fonctionnement étant suffisant pour efficacement amplifier des signaux d'entrée, modulés avec une forme d'onde de bande de base d'une amplitude supérieure audit niveau de référence.

12. Appareil pour améliorer l'efficacité et la plage dynamique d'un amplificateur de puissance (204), comprenant :
a) un circuit d'échantillonnage (201) pour échantillonner en continu l'amplitude d'un signal d'entrée qui est un signal modulé introduit audit amplificateur de puissance, ou une forme d'onde de bande de base utilisée pour générer ledit signal modulé, pour détecter un signal d'entrée excessif (ES), selon un niveau de référence (L) prédéterminé, au-dessus duquel au moins une partie dudit signal d'entrée est définie comme étant le signal d'entrée excessif ; et
b) une alimentation de puissance, pour alimenter en tension de fonctionnement ledit amplificateur de puissance ;
**caractérisé en ce qu'**il comprend en outre :
c) un circuit de commande (202) fonctionnant en combinaison avec ladite alimentation de puissance, pour que l'alimentation de puissance fournisse un niveau constant de tension de fonctionnement (+Bc), suffisant pour efficacement amplifier des signaux d'entrée (Ven(t)) d'une amplitude inférieure audit niveau de référence, audit amplificateur de puissance, si aucun signal d'entrée excessif n'est détecté, et pour simultanément alimenter ledit amplificateur de puissance, si un signal d'entrée excessif est détecté, un niveau augmenté variable de tension de fonctionnement (EV) qui essentiellement poursuit l'amplitude dudit signal d'entrée excessif et soit suffisant pour efficacement amplifier des signaux d'entrée ayant une amplitude supérieure audit niveau de référence.

13. Appareil selon la revendication 12, comprenant en outre :
a) un circuit de commande automatique de gain (209), couplé à l'entrée dudit amplificateur de puissance (204), pour commander l'amplitude du ou desdits signaux d'entrée (Ven(t)) avant l'amplification ;
b) une circuiterie (201) pour échantillonner ledit signal d'entrée excessif (ES) ; et
c) une circuiterie de commande (202) pour compenser les changements intervenus dans le gain dudit amplificateur de puissance durant la présence dudit signal d'entrée excessif, par commande du gain dudit circuit de commande automatique de gain, selon les échantillons dudit signal d'entrée excessif.

14. Appareil selon la revendication 12, comprenant :
a) une première source de tension (+Bc), pour alimenter ledit amplificateur de puissance ;
b) une deuxième source de tension (+Bv), pour alimenter ledit amplificateur de puissance, si un signal d'entrée excessif (ES) est détecté ;
c) une impédance variable (203), connectée entre l'entrée d'alimentation de tension dudit amplificateur de puissance et ladite deuxième source de tension ;
d) une impédance variable (205) supplémentaire, connectée entre l'entrée d'alimentation de tension dudit amplificateur de puissance et ladite première source de tension (+Bc) ; et
e) un circuit de commande (202), pour commander ladite impédance variable pour qu'elle se trouve à son état l'impédance haute si aucun signal d'entrée excessif n'est détecté, et qu'elle soit à un état l'impédance basse si un signal d'entrée excessif est détecté, ledit état l'impédance basse étant essentiellement égal à la valeur nécessaire pour augmenter ladite deuxième source de tension pour arriver à un niveau capable de poursuivre l'amplitude dudit signal d'entrée excessif.

15. Appareil selon la revendication 12, comprenant :
a) une première source de tension (+Bc), pour alimenter ledit amplificateur de puissance (204) ;
b) une deuxième source de tension (+Bv), pour additionnellement alimenter ledit amplificateur de puissance, si un signal d'entrée excessif est détecté ;
c) un amplificateur de tension (203), connecté entre le contact d'alimentation en tension dudit amplificateur de puissance et ladite deuxième source de tension, pour fournir un niveau de tension, supérieur à la tension de ladite première source de tension, audit contact d'alimentation de tension dudit amplificateur de puissance ; et
d) un circuit de commande (202), pour commander ledit amplificateur de tension pour fournir un niveau de tension, supérieur à la tension de ladite première source de tension, audit contact d'alimentation de tension dudit amplificateur de puissance, si aucun signal d'entrée excessif n'est détecté.

16. Appareil selon la revendication 14 ou 15, dans lequel une alimentation de puissance supplémentaire fournit la deuxième source de tension (+Bv) si un signal d'entrée excessif est détecté.

17. Appareil selon la revendication 14, dans lequel l'impédance variable est une l'impédance pouvant être commandée.

18. Appareil selon la revendication 14, dans lequel l'impédance variable est une inductance ou une diode.

19. Appareil selon la revendication 17, dans lequel l'impédance pouvant être commandée est un transistor bipolaire ou un FET.

20. Appareil selon la revendication 12, comprenant en outre :
a) un circuit d'échantillonnage, pour échantillonner le niveau de tension de fonctionnement fourni audit amplificateur de puissance (204) ;
b) un comparateur (210), pour générer une différence de tension, par comparaison du niveau échantillonné de tension de fonctionnement (Vout(t)), fourni audit amplificateur de puissance, au niveau du signal d'entrée excessif (ES) ; et
c) une boucle à réaction négative pour commander de façon précise la tension de fonctionnement fournie audit amplificateur de puissance, par utilisation de ladite différence de tension.

21. Appareil selon la revendication 12, comprenant en outre :
a) un circuit d'échantillonnage (402) pour échantillonner le niveau des signaux de sortie RF, amplifiés par ledit amplificateur de puissance ;
b) un comparateur (401) pour générer une différence de tension par comparaison entre le niveau échantillonné des signaux de sortie RF, amplifiés par ledit amplificateur de puissance (204), au niveau du signal d'entrée excessif (ES) ; et
c) une boucle à réaction négative, pour commander précisément la tension de fonctionnement fournie audit amplificateur de puissance, par utilisation de ladite différence de tension.

22. Appareil selon la revendication 12, comprenant :
a) un modulateur (303), pour générer un signal modulé introduit à l'amplificateur de puissance (204) ;
b) une source de signal de bande de base (302), pour générer une forme d'onde de bande de base qui est introduite audit modulateur ;
c) un limiteur de tension à seuil (305), pour extraire un signal d'entrée excessif (ES) de la forme d'onde de bande de base, lorsque l'amplitude de la forme d'onde de bande de base dépasse un niveau de référence (L) ;
d) une alimentation de puissance pour fournir une tension de fonctionnement audit amplificateur de puissance ; et
e) un circuit de commande (300), fonctionnant en combinaison avec ladite alimentation de puissance, pour faire fournir par ladite alimentation de puissance un niveau constant (+Bc) de tension de fonctionnement, suffisant pour efficacement amplifier des signaux d'entrée ayant une amplitude inférieure audit niveau de référence, audit amplificateur de puissance, si aucun signal d'entrée excessif n'est détecté, et pour fournir un niveau augmenté variable (+Bc + EV) de tension de fonctionnement, suffisant pour efficacement amplifier des signaux d'entrée ayant une amplitude supérieure audit niveau de référence, audit amplificateur de puissance, si un signal d'entrée excessif est détecté.

23. Un procédé selon la revendication 1, dans lequel l'amplificateur de puissance est le circuit d'amplification auxiliaire (256) d'une *configuration Doherty.*

24. Un procédé selon la revendication 23, comprenant :
a) la fourniture d'une *configuration Doherty*, constituée d'un amplificateur auxiliaire (204), directement connecté à une charge (251), et d'un amplificateur principal (253) couplé à ladite charge par l'intermédiaire d'un *coupleur Doherty* (252) ;
b) la détermination d'un niveau de référence (L), au-dessus duquel une partie de l'amplitude d'un signal d'entrée (18), qui est un signal modulé introduit audit amplificateur de puissance, ou une forme d'onde de bande de base, utilisée pour générer ledit signal modulé, est définie comme étant un signal d'entrée excessif (ES), de manière que ledit niveau de référence soit essentiellement égal au niveau du signal d'entrée, provoquant de la part des circuits d'amplificateur principal (255) et auxiliaire (526) la fourniture pratiquement de la même puissance dans la charge, de manière à atteindre le niveau de puissance de sortie maximal sous ladite tension de fonctionnement en courant continu CC ;
c) l'échantillonnage en continu de ladite amplitude dudit signal d'entrée, afin de détecter un signal d'entrée excessif ;
d) l'amplification en continu du signal d'entrée avec ledit amplificateur principal, par fourniture d'une tension de fonctionnement (+Bc) constante à ladite circuiterie d'amplificateur principale ;
e) tant qu'aucun signal d'entrée excessif n'est détecté, l'amplification du signal d'entrée à l'aide de la circuiterie d'amplificateur auxiliaire, par fourniture, audit amplificateur auxiliaire, de la même tension de fonctionnement CC fournie audit amplificateur principal ; et
f) si un signal d'entrée excessif est détecté, la fourniture simultanée d'un niveau augmenté variable de tension de fonctionnement CC (Bc + EV) à ladite circuit d'amplificateur auxiliaire, ledit niveau amélioré de tension de fonctionnement étant suffisant pour efficacement amplifier des signaux d'entrée ayant ladite amplitude supérieure audit niveau de référence.

25. Appareil selon la revendication 12, dans lequel l'amplificateur de puissance est une circuiterie amplificatrice auxiliaire (256) utilisée dans une *configuration Doherty,* la sortie de ladite circuiterie amplificatrice auxiliaire étant directement connectée à une charge (251) et étant exploitée en combinaison avec un amplificateur principal (253) couplé à ladite charge par l'intermédiaire d'un *coupleur Doherty* (252), l'entrée de ladite circuiterie amplificatrice auxiliaire étant couplée à l'entrée dudit amplificateur principal, par l'intermédiaire d'une circuiterie de déphasage (254) ayant un déphasage sensiblement similaire au déphasage ayant été introduit par ledit *coupleur Doherty.*
